# EUROPEAN PATENT APPLICATION

(11) **EP 1 391 764 A2**
(43) Date of publication of application: **25.02.2004**
(21) Application number: 03102472.2
(22) Date of filing: 07.08.2003
(51) Int. Cl.: G02B 6/42

(54) **A linear diode laser array light coupling apparatus**

(30) Priority: 14.08.2002 US 64758
(71) Applicant: Ford Global Technologies, LLC, Dearborn, Michigan 48126 (US)
(72) Inventor: Fohl, Timothy, Carlisle, MA 01741 (US); Remillard, Jeffrey, Thomas, Ypsilanti, MI 48197 (US); Weber, Willes, Ann Arbor, MI 48104 (US)
(74) Representative: Messulam, Alec Moses

(57) **Abstract**

A light coupling element and a light coupling apparatus for coupling a linear diode laser array to an optical fibre are disclosed. The light coupling apparatus 16 includes a cylindrical lens 50 positioned adjacent and substantially parallel to a linear diode laser array 10. The cylindrical lens 50 has a length substantially equal to the length of the linear diode laser array 10 and receives emitted light from the plurality of diode lasers within the linear diode laser array 10 to collimate the light. The collimated light is received by a wedge-shaped coupling element 52 between the cylindrical lens 50 and an optical fibre 14. The coupling element 52 has a length (L) extending from an input surface 60 to an output surface 66. The width of the input surface 60 is substantially equal to a diameter of the cylindrical lens 50 and the width of the output surface 66 is substantially equal to a diameter of the input end of the optical fibre 14.

## Description

The present invention relates to a linear diode laser array light coupling apparatus and in particular to a light coupler for carrying laser light from a linear diode array to an optical element using an optical fibre.

Conventional lighting systems used in automotive vehicle applications such as headlights and tailights utilize an incandescent bulb with a reflector. The light emitted from the incandescent bulb is generally collimated by the reflector. The incandescent bulb is used to generate light in the visible spectrum for headlight and taillight applications. In other vehicle applications, such as active night vision systems, near-infrared light is required that is compatible with solid-state CCD or CMOS cameras to illuminate a region proximate the vehicle.

Advances in solid-state lasers have given rise to thin-sheet lighting systems for use in tailight and active night vision systems. The thin-sheet systems require less space than traditional bulb and reflector systems. Furthermore, laser diodes are more energy efficient and reliable than incandescent bulbs. A challenge in thin-sheet lighting systems is to rapidly spread the laser light over a sufficiently wide area to meet spatial illumination requirements for good visibility and, at the same time, eye safety requirements as mandated under laws governing such applications.

U.S. Patent Application Serial No. 09/688,992 entitled "Thin-Sheet Collimation Optics For Diode Laser Illumination Systems For Use In Night Vision and Exterior Lighting Applications" filed October 17, 2000 describes thin-sheet collimation optics which can be used to produce eye-safe diode laser-based headlamps for night vision applications. Other patents describe diode laser-based signal lamps, which use thin-sheet optics to form beam patterns. To minimize the optical lamp depth, it is advantageous to convey the laser light from the diode laser source to the optical lamp using an optical fibre. Performance, styling, and packaging advantages of such thin-sheet optical elements can be improved through the use of a fibre-coupled diode laser array.

In light applications such as the foregoing, it is necessary to couple the diode laser array to a multimode optical fibre. Typically, the optical fibre is butt-coupled to each laser diode such that the optical fibre is as close as possible to the laser diode. This is desirable because the laser diode output has a high divergence angle in the direction perpendicular to the diode junction. Thus, the optical fibre must be placed very close to the diode laser to efficiently receive the emitted light. Accurate placement of the optical fibre within small tolerances required for efficient coupling is difficult to achieve.

Accordingly, a variety of techniques have been disclosed for coupling the output of a multiple diode laser array into a multi-mode optical fibre. For example, U.S. Patent No. 5,436,990 discloses a coupling method using a single, small diameter optical fibre to collimate the fast axis of each diode laser within the array. The collimated output of each laser is then butt-coupled to its own optical fibre. Thus, the coupling technique requires the precise positioning of numerous optical fibres, one optical fibre for each diode laser within the array. Other known coupling techniques require the positioning of individual micro-lenses to condition the output of each diode laser within the array or the reception by either another array of lenses or a single lens to direct the light into a single optical fibre.

Each of these known light coupling techniques requires the precise position of either lenses, fibres, or both in front of each individual diode laser within the array.

Accordingly, it is an object of this invention to provide an apparatus and method that does not require precise alignment of either lenses or fibres to couple a linear diode laser array to an optical fibre.

According to a first embodiment of a first aspect of the invention there is provided a light coupling element for coupling a linear diode laser array to an optical fibre characterised in that the coupling element comprises a wedge-shaped coupling element having a height (h) substantially equal to a length defined by the linear diode laser array, the coupling element having a length (L) extending from an input surface to an output surface, the input surface receiving emitted light from a plurality of diode lasers within the linear diode laser array and has a first width (w1) facetted in a direction along the height (h) to direct the light towards the output surface which is of a second width (w2) and is curved in a direction perpendicular to the height (h) to substantially collimate the light.

The first width (w1) may be greater than or equal to the second width (w2).

The second width (w2) may be substantially equal to a diameter of the optical fibre.

According to a second embodiment of the first aspect of the invention there is provided a light coupling apparatus for coupling a linear diode laser array to an optical fibre characterised in that the apparatus comprises a cylindrical lens positioned adjacent to and substantially parallel to the linear diode laser array, the cylindrical lens having a length substantially equal to a length of the linear diode laser array and being arranged to receive emitted light from a plurality of diode lasers within the linear diode laser array and collimating the light and further comprises a wedge-shaped coupling element between the cylindrical lens and the optical fibre having a length (L) extending from an input surface to an output surface, the input surface having a radius of curvature along a height (h) substantially equal to the length of the cylindrical lens and having an associated first width (w1) and the output surface having an associated second width (w2) such that the coupling element tapers from the input surface to the output surface wherein the first width (w1) is substantially equal to a diameter of the cylindrical lens and the second width (w2) is substantially equal to the diameter of the optical fibre.

The linear diode array may comprise of a plurality of spaced apart diode lasers and the length of the cylindrical lens may be equal to a length of the plurality of diode lasers.

An optical fibre may be positioned adjacent the output surface of the coupling element.

The first width may be greater than or equal to the second width.

The cylindrical lens may have one of a circular, elliptical and hyperbolic cross-section.

The coupling element length (L) may be approximately 10mm and the first and second widths are approximately 1 to 3 mm.

The cylindrical lens may be positioned a first distance (d1) from the linear diode laser array and the input surface of the coupling element may be positioned a second distance (d2) from the cylindrical lens.

The first and second distances (d1 and d2) are substantially equal.

The radius of curvature of the coupling element input surface may be configured to minimize reflection received light from interior sides of the coupling element.

The coupling element length (L) and the input surface height (h) may be configured such that an angular spread of light within the coupling element matches an acceptance angle of the optical fibre.

According to a first embodiment of a second aspect of the invention there is provided a method of coupling the output of a linear diode laser array into an end of an optical fibre by means of a coupling element characterised in that the method comprises the steps of optically coupling along a linear axis spaced at a first distance (d1) from the linear diode laser array a wedge-shaped coupling element having a height (h) substantially equal to a length defined by the linear diode laser array, the coupling element receiving emitted light from a plurality of diode lasers within the array and directing the light toward an output surface having a second width (w2) by way of an input surface having a first width (w1) facetted in a direction along the height (h) and curved in a direction perpendicular to the height (h) and optically coupling light from the output surface into an end of the optical fibre having a diameter substantially equal to the second width (w2).

The first width may be greater than or equal to the second width.

According to a second embodiment of a second aspect of the invention there is provided a method of coupling the output of a linear diode laser array into an end of an optical fibre by means of a light coupling apparatus characterised in that the method comprises the steps of optically coupling along a linear axis spaced at a first distance (d1) from the linear diode laser array a cylindrical lens having a length substantially equal to a length defined by the linear diode laser array, the cylindrical lens receiving emitted light from a plurality of diode lasers within the array and collimating the light, optically coupling the collimated light from the cylindrical lens into a wedge-shaped coupling element positioned at a second distance (d2) from the cylindrical lens and having a length (L) extending from an input surface to an output surface, the input surface having a radius of curvature along a height (h) which is substantially equal to the length of the cylindrical lens and an associated first width (w1) substantially equal to a diameter of the cylindrical lens and the output surface having an associated second width (w2) substantially equal to a diameter of an optical fibre wherein the coupling element tapers from the input surface to the output surface and the output surface optically couples light into an end of the optical fibre.

The first width may be greater than or equal to the second width.

The cylindrical lens may have one of a circular, elliptical and hyperbolic cross-section.

In its broadest sense the invention may comprise of a means to provide a source of collimated light to a wedge-shaped coupling element having a height (h) substantially equal to a length of the linear diode laser array, an input surface of width (w1) and an output surface of width (w2).

The invention will now be described by way of example with reference to the accompanying drawing of which:-
Figure 1 is a schematic block diagram of a night vision system in which the present invention may be used to advantage;
Figure 2 is a perspective view of an emission pattern of one diode laser within an array of diode lasers;
Figure 3 is a side view of a linear diode laser array light coupling apparatus in accordance with one embodiment of the present invention;
Figure 4 is a top view of the linear diode laser array light coupling apparatus of Figure 3;
Figure 5 is a side view of a linear diode laser array light coupling apparatus in accordance with a second embodiment of the present invention; and
Figure 6 is a top view of the linear diode laser array light coupling apparatus of Figure 5.

While the present invention is described with respect to a light coupling apparatus for a linear diode laser array within the environment of an active night vision system of a vehicle, the present invention may be adapted and utilized for numerous other applications including headlamp, tailamp, and signal lamp illumination applications as well as non-vehicle related illumination applications wherein it is desirable to couple an array of laser light sources to a single multi-mode optical fibre.
In the following description, various operating parameters and components are described for one constructed embodiment. These specific components and parameters are included as examples and are not meant to be limiting.

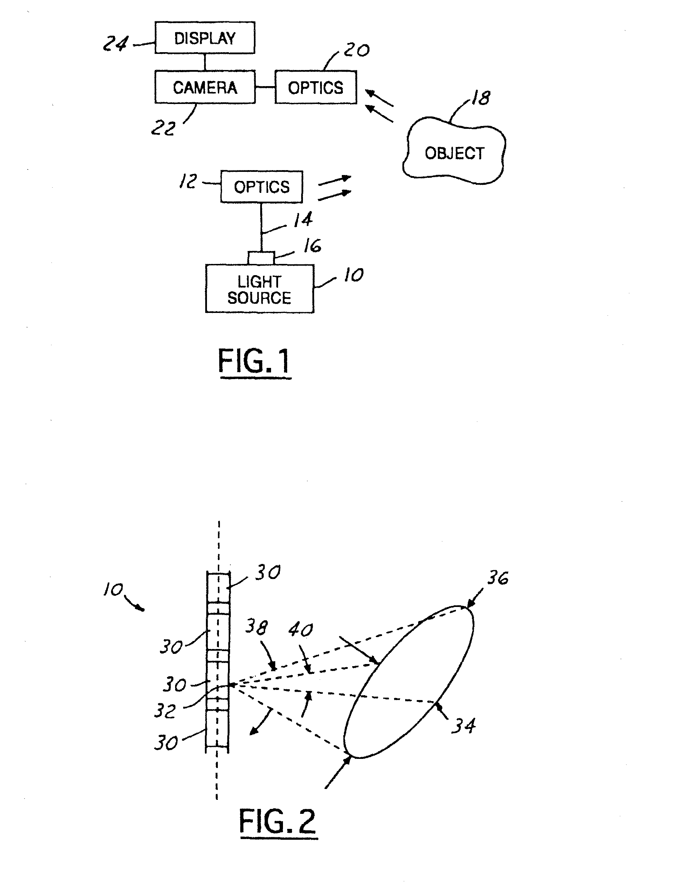

Referring now to the drawings wherein like reference numerals are used to identify identical components in the various views, Figure 1 illustrates a schematic block diagram of an active night vision system for a vehicle wherein the present light coupling apparatus may be used to advantage.

In this example, a light source 10 is used to generate near-infrared light. An optical element 12, such as a thin-sheet optical element, receives the light from the light source 10 by way of a fibre optic cable 14. The light source 10 is connected to a first end of the fibre optical cable 14 by a light coupler 16 in accordance with the present invention.

The fibre optic cable 14 is utilized to transmit light from the light source 10 to the optical element 12. The fibre optic cable is a single multi-mode optical fibre having a diameter of < 1mm and a numerical aperture of 0.15-0.4, for example.
The optical element 12 receives the light from the fibre optic cable 14 through an input surface, conditions the light by reflection to form a desired beam pattern and transmits the light through an output surface to illuminate a region proximate the vehicle such as in a forward direction of travel.

The optics 12 may include additional diffusers, lenses, diffractive optics, or any other optical devices adjacent or adjoining the output surface to manipulate the laser light to create a desired illumination pattern ahead of the night vision system.

Light emitted from the optical elements 12 illuminates objects such as object 18 within the field-of-view of the night vision system. Object 18 reflects the laser light back toward the night vision system. Optical elements 20 process the light reflected from object 18 and communicate desired light data to a camera 22. The camera 22 processes the light data and presents it to a display 24 such that the object information can be made known to the system user. Optics 20 typically include a narrow band filter to shield the camera 22 from light outside of the range of interest which is typically the near-infrared range.

Referring now to Figure 2 there is shown a perspective view of an emission pattern of one of the diode lasers within the linear diode laser array comprising the light source 10 of Figure 1.

The light source 10 comprises a linear diode laser array that includes a plurality of laser diodes 30. The diode lasers 30 are lineally spaced and each includes an emitting aperture 32 which represents the emitting end of an optical resonator having dimensions that are substantially equal to the active junction area of the diode laser. Each diode laser in the linear array emits light along a slow axis 34 and a fast axis 36. The fast axis 36 is associated with a first divergent emission angle 38 and the slow axis 34 is associated with a second divergent emission angle 40.

The ratio of divergence between the first and second divergent emission angles 38, 40 is approximately 3:1, with typical values for the first divergent emission angle 38 and second divergent emission angle 40 being 35° and 10°, respectively. The first and second divergent emission angles 38 and 40 may be larger or smaller, however, depending upon the type and design of the laser light source 30. Also, the first and second divergent emission angles 38, 40 are normal to each other, with the laser light generally diverging more rapidly along the fast axis than the slow axis. Further, the fast axis is generally perpendicular to the diode junction. With regard to the linear diode laser array, an exemplary rectangular dimension for each emitting aperture 32 is approximately 1x80 microns and an exemplary laser diode spacing is on the order of 200 microns. The entire linear diode laser array may be on the order of one centimetre in length.

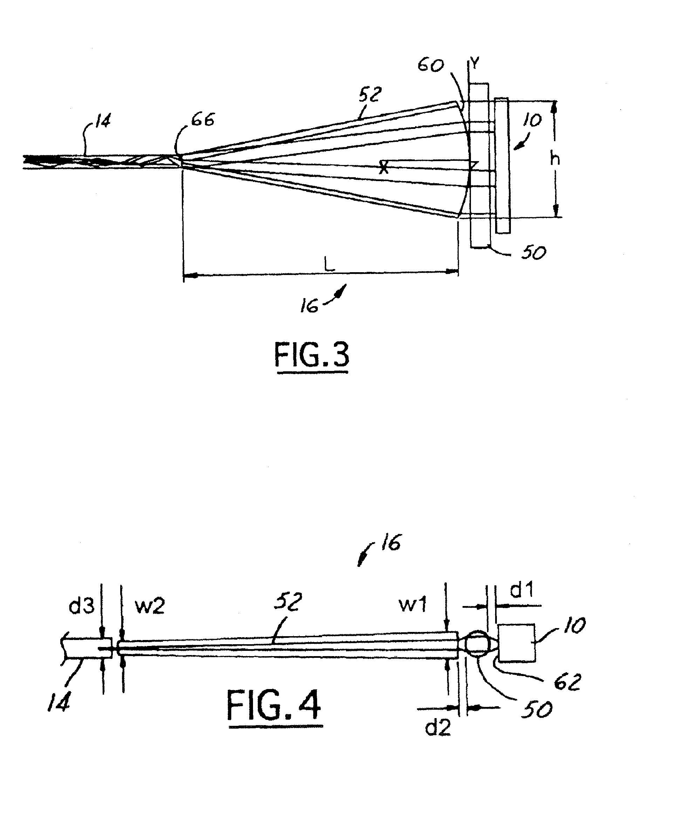

Referring now to Figure 3, there is shown a side view of a linear diode laser array light coupling apparatus 16 in accordance with a second embodiment of the present invention.

The coupling apparatus 16 includes a cylindrical lens 50 and a tapered, wedge-shaped coupling element 52 between the diode laser array 10 and the multi-mode optical fibre 14. The cylindrical lens 50 is located adjacent the diode laser array 10 substantially abutting the plurality of emitting apertures associated with the plurality of diode lasers within the array 10. The cylindrical lens 50 acts to collimate light emitted from the diode laser array for reception by the coupling element 52.

Referring now to Figure 4, there is shown a top view of the linear diode laser array light coupling apparatus of Figure 3. The cylindrical lens 50 is preferably a glass or polycarbonate material and has a circular cross-section. Other cross-sectional shapes, however, such as elliptical or hyperbolic, could also be used for the cylindrical lens 50.

As shown in Figure 4, the cylindrical lens is placed at a distance d1 from the diode laser array 10. Likewise, the coupling element 52 is placed at a distance d2 from the cylindrical lens 50. The values for d1 and d2 depend upon the index of refraction for the cylindrical lens 50 as well as its radius of curvature. Preferably, however, the values of d1 and d2 should be as small as possible to increase the efficiency of the light coupling.

In cases where collimation of the diode laser light is not desirable, such as when refocusing of the divergent emission from the diode laser is desired, the distance d1 between the diode laser array and the cylindrical lens may be varied by known methods to achieve the desired light behaviour, or the cross-sectional shape of the cylindrical lens 50 may be modified to be something other than circular. In addition, the distance d2 between the cylindrical lens 50 and coupling element 52 may be varied to achieve various desired focusing patterns for the emitted diode laser light.

Preferably, the length of the cylindrical lens 50 is greater than or equal to the length of the diode laser array and the height (h) of the input surface 60 of the coupling element 52. In addition, the diameter of the cylindrical lens 50 is preferably greater than or equal to the width of the emitting surface 62 of the diode laser array 10. As the distance d1 increases, the diameter of the cylindrical lens preferably increases to redirect the rapidly diverging light towards the input surface 60 of the coupling element 52.

The coupling element 52 is preferably glass or polycarbonate material or other suitable plastic. The coupling element 52 tapers along its length (L) from its input surface 60 to the output surface 66 which adjoins the input of the multimode optical fibre 14. The width w1 of the input surface 60 of the coupling element 52 is less than or equal to the diameter of the cylindrical lens 50. The width w2 of the output surface 66 can be less than or equal to the width w1 of the input surface. The width w2 of the output surface 66 is preferably also less than the diameter d3 of the multimode optical fibre 14.

Thus, as shown in Figure 3, the coupling element 52 preferably tapers from its input surface 60 to its output surface 66 along its length L and, as shown in Figure 4, the coupling element either is of a constant width (w1=w2) or tapers from its input surface to its output surface along the length L (w1>w2). The interior surfaces of the coupling element are preferably configured and/or coated to achieve total internal reflection of the laser light toward the input end of the optical fibre 14.

In one example, the cylindrical lens 50 is approximately 1 to 3 mm in diameter, the widths of the coupling element 52 at its input and output (w1, w2) are 1 to 3 mm, the length (L) of the coupling element 52 is approximately 30 mm and the height (h) of the coupling element 52 is approximately 10 mm. The multimode optical fibre is a large diameter optical fibre that is approximately 1 to 3 mm in diameter.

In operation, light emitted from the diode laser array is collimated by the cylindrical lens 50. Thus, the divergence of each diode laser within the array along its fast axis is redirected by the cylindrical lens to have a divergence angle of approximately zero (collimated light). The parallel collimated light is then received by the input surface 60 of the coupling element 52. The input surface 60 of the coupling element 52 has a predetermined radius of curvature to direct the light towards the output surface 66 and, hence, the input of the multimode optical fibre 14. The length (L) and height (h) of the coupling element 52 is selected to ensure that the angular spread of light within the coupling element 52 matches the acceptance angle of the optical fibre 14. The dimensions for L, h, w1, and w2 are also selected to minimize reflection of the laser light from the sides of the coupling element 52.

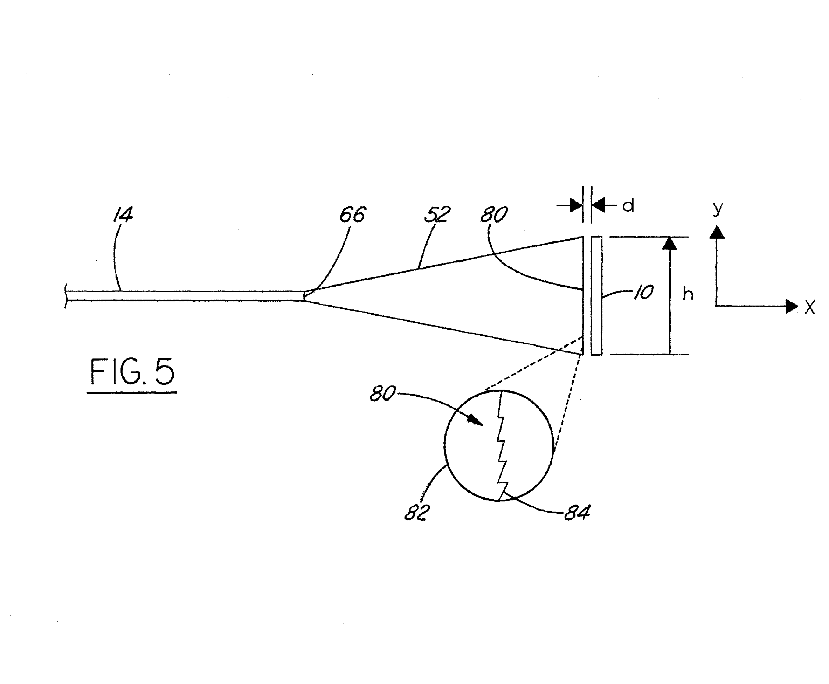

Referring now to Figure 5, there is shown a side view of a linear diode laser array light coupling element in accordance with a first embodiment of the present invention. Like features of the second embodiment are identified with the same reference numerals as the light coupling apparatus of Figures 3 and 4.

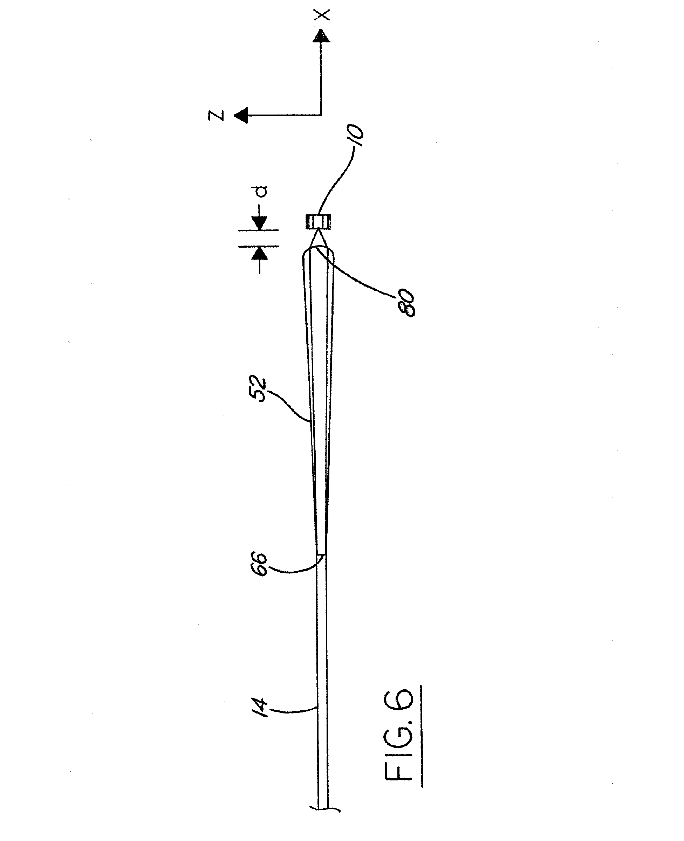

The only difference between the embodiment of Figures 5 and 6 and the embodiment shown in Figures 3 and 4 is the elimination of the cylindrical lens, and the contours of the input surface 80 of the coupling element 52.

In the y direction, the input surface 80 of coupling element 52 is facetted as shown schematically in the magnified view 82. The facet angle 84 in the y direction of each facet is chosen such that light emitted from each diode emitter is refracted toward the exit aperture 66. These facets act in the same way in the y direction as the curved input surface 60 of Figure 3.

Figure 6 shows a top view of the light coupling apparatus of Figure 5. The spacing d1 and the curvature of the input surface 80 in the z direction are configured such that light diverging in the fast axis is substantially collimated and directed toward the exit aperture 66. The input surface 60 thus acts similar to the cylindrical lens in the first embodiment of the invention.

The combination of the cylindrical lens 50 and coupling element 52 in the second embodiment, or the use of a complex entrance surface for the coupling element 52 in the second embodiment permit a relatively high efficiency light coupling system without the need to precisely position a plurality of optical fibres or micro-lenses. The coupling efficiency realized by the present invention is satisfactory for automotive lighting applications including night vision system illuminating sources, convenience lighting, and head lamp and tail lamp beam forming applications.

From the foregoing, it can be seen that there has been brought to the art a new and improved light coupling apparatus which has advantages over prior light coupling devices.

Therefore in summary, the present invention provides a light coupling apparatus for coupling a linear diode laser array to an optical fibre. In one embodiment of the invention a light coupling apparatus is provided having a cylindrical lens positioned adjacent and substantially parallel to the linear diode laser array to receive emitted light from the plurality of diode lasers within the linear diode laser array and to collimate the light. The collimated light is received by a wedge-shaped coupling element between the cylindrical lens and the optical fibre.

The coupling element has a length (L) extending from an input surface to an output surface. The input surface defines a radius of curvature along a height (h) which is substantially equal to the cylindrical lens length. The coupling element tapers from its input surface to its output surface. The input surface also has an associated width (w1), and the output surface has an associated width (w2). The input surface width is substantially equal to a diameter of the cylindrical lens, and the output surface width is substantially equal to a diameter of the input end of the optical fibre.

In another embodiment of the invention the cylindrical lens is eliminated and so only an optical coupling element is used. The function of the cylindrical lens is in this case is performed by the entrance surface of the wedge-shaped coupling element. The entrance surface is a Fresnel type sequence of facetted, curved surfaces in the direction along the height (h). In this direction, the curvature of each facet along the height (h) is the same as in the first embodiment. In the direction along the width (w1), each facetted surface has a convex curvature so as to collimate the fast axis of the diode laser emission. The entrance surface of the wedge-shaped coupling element is positioned approximately at the same distance (d1) from the diode laser array as was the cylinder lens in the first embodiment.

The present invention is therefore advantageous in that it provides an uncomplicated and inexpensive fibre coupling apparatus which does not require precise alignment of multiple lenses or fibres to couple a single multi-mode optical fibre to a diode laser array. The present invention avoids the critical placement problems associated with prior light coupling techniques.

While the invention has been described in connection with one or more embodiments, it should be understood that the invention is not limited to those embodiments. On the contrary, the invention covers all alternatives, modifications and equivalents as may be included within the scope of the invention.

## Claims

1. A light coupling element (52) for coupling a linear diode laser array (10) to an optical fibre (14) **characterised in that** the coupling element comprises a wedge-shaped coupling element (52) having a height (h) substantially equal to a length defined by the linear diode laser array (10), the coupling element (52) having a length (L) extending from an input surface (80) to an output surface (66), the input surface (80) receiving emitted light from a plurality of diode lasers within the linear diode laser array (10) and has a first width (w1) facetted in a direction along the height (h) to direct the light towards the output surface (66) which is of a second width (w2) and is curved in a direction perpendicular to the height (h) to substantially collimate the light.

2. A light coupling element as claimed in claim 1 wherein the first width (w1) is greater than or equal to the second width (w2).

3. A light coupling element as claimed in claim 1 or in claim 2 wherein the second width (w2) is substantially equal to a diameter of the optical fibre (14).

4. A light coupling apparatus (16) for coupling a linear diode laser array (10) to an optical fibre (14) **characterised in that** the apparatus comprises a cylindrical lens (50) positioned adjacent to and substantially parallel to the linear diode laser array (10), the cylindrical lens (50) having a length substantially equal to a length of the linear diode laser array (10) and being arranged to receive emitted light from a plurality of diode lasers within the linear diode laser array (10) and collimating the light and further comprises a wedge-shaped coupling element (52) between the cylindrical lens (50) and the optical fibre (14) having a length (L) extending from an input surface (60) to an output surface (66), the input surface (60) having a radius of curvature along a height (h) substantially equal to the length of the cylindrical lens (50) and having an associated first width (w1) and the output surface (66) having an associated second width (w2) such that the coupling element (52) tapers from the input surface (60) to the output surface (66) wherein the first width (w1) is substantially equal to a diameter of the cylindrical lens (50) and the second width (w2) is substantially equal to the diameter of the optical fibre (14).

5. A light coupling apparatus as claimed in claim 4 wherein the first width is greater than or equal to the second width.

6. A light coupling apparatus as claimed in claim 4 or in claim 5 wherein the cylindrical lens (50) has one of a circular, elliptical and hyperbolic cross-section.

7. A light coupling apparatus as claimed in any of claims 4 to 6 wherein the coupling element length (L) is approximately 10mm and the first and second widths are approximately 1 to 3 mm.

8. A light coupling apparatus as claimed in any of claims 4 to 7 wherein the cylindrical lens (50) is positioned a first distance (d1) from the linear diode laser array (10) and the input surface (60) of the coupling element (52) is positioned a second distance (d2) from the cylindrical lens (50) .

9. A light coupling apparatus as claimed in claim 8 wherein the first and second distances (d1 and d2) are substantially equal.

10. A light coupling apparatus as claimed in any of claims 4 to 9 wherein the radius of curvature of the coupling element input surface (60) is configured to minimize reflection received light from interior sides of the coupling element.

11. A light coupling apparatus as claimed in any of claims 4 to 10 wherein the coupling element length (L) and the input surface height (h) are configured such that an angular spread of light within the coupling element (52) matches an acceptance angle of the optical fibre (14).

12. A method of coupling the output of a linear diode laser array (10) into an end of an optical fibre (14) by means of a coupling element (52) **characterised in that** the method comprises the steps of optically coupling along a linear axis spaced at a first distance (d1) from the linear diode laser array a wedge-shaped coupling element (52) having a height (h) substantially equal to a length defined by the linear diode laser array (10), the coupling element (52) receiving emitted light from a plurality of diode lasers within the array (10) and directing the light toward an output surface (66) having a second width (w2) by way of an input surface (80) having a first width (w1) facetted in a direction along the height (h) and curved in a direction perpendicular to the height (h) and optically coupling light from the output surface (66) into an end of the optical fibre (14) having a diameter substantially equal to the second width (w2).

13. A method of coupling the output of a linear diode laser array (10) into an end of an optical fibre (14) by means of a light coupling apparatus (16) **characterised in that** the method comprises the steps of optically coupling along a linear axis spaced at a first distance (d1) from the linear diode laser array a cylindrical lens (50) having a length substantially equal to a length defined by the linear diode laser array (10), the cylindrical lens (50) receiving emitted light from a plurality of diode lasers within the array and collimating the light, optically coupling the collimated light from the cylindrical lens (50) into a wedge-shaped coupling element (52) positioned at a second distance (d2) from the cylindrical lens (50) and having a length (L) extending from an input surface (60) to an output surface (66), the input surface (60) having a radius of curvature along a height (h) which is substantially equal to the length of the cylindrical lens (50) and an associated first width (w1) substantially equal to a diameter of the cylindrical lens (50) and the output surface (66) having an associated second width (w2) substantially equal to a diameter of an optical fibre (14) wherein the coupling element (52) tapers from the input surface (60) to the output surface (66) and the output surface (66) optically couples light into an end of the optical fibre (14).
